# EUROPÄISCHE PATENTANMELDUNG

(11) **EP 4 700 516 A1**
(43) Veröffentlichungstag der Anmeldung: **25.02.2026**
(21) Anmeldenummer: 24195576.4
(22) Anmeldetag: 21.08.2024
(51) Int. Cl.: G05B 23/02, G01R 31/42, H02M 1/32

(54) **CONDITION MONITORING VON ANTRIEBSSYSTEMEN**

(71) Anmelder: Siemens Aktiengesellschaft, 80333 München (DE); Karlsruher Institut für Technologie, 76131 Karlsruhe (DE)
(72) Erfinder: Köllensperger, Peter, 90562 Heroldsberg (DE); Liske, Andreas, 76327 Pfinztal (DE); Schmitz-Rode, Benedikt, 76185 Karlsruhe (DE); Hiller, Marc, 75015 Bretten (DE); Tsotoulidis, Savvas, 35132 Lamia (GR)
(74) Vertreter: Siemens Patent Attorneys

(57) **Zusammenfassung**

Die Erfindung betrifft ein Computer-implementiertes Verfahren, eine Computer-implementierte Vorrichtung, ein System und ein Computerprogrammprodukt zum Bestimmen eines Degradationsfortschritts eines Stromrichters und/oder eines elektrischen Antriebsmittels, umfassend Erfassen eines zeitlichen Verlaufs einer initialen mit einer Reglung einer Ausgangsspannung und/oder einem Ausgangsstrom assoziierten zumindest einen Zustandsgröße, wobei die Ausgangsspannung und/oder der Ausgangsstrom des Stromrichters zur Zuführung an das elektrische Antriebsmittel bestimmt ist, Erfassen eines zeitlichen Verlaufs der zumindest einen Zustandsgröße zu einem späteren, von einem mit der initialen Zustandsgröße assoziierten, verschiedenem Zeitpunkt, Bestimmen, ob eine Abweichung eines mit dem erfassten zeitlichen Verlaufs der Zustandsgröße zu dem späteren Zeitpunkt assoziierten Wertes von einem mit dem erfassten zeitlichen Verlaufs der initialen Zustandsgröße assoziierten Werts eingetreten ist, Bestimmen, falls eine Abweichung bestimmt wurde, einer mit einer Degradation des Stromrichters assoziierten Zeitkonstante mit welcher die Abweichung eingetreten ist und Bestimmen, zumindest teilweise basierend auf der Zeitkonstante, einer Degradationsursache und eines Degradationsfortschritts, zumindest teilweise basierend auf einem Vergleichen der bestimmten Abweichung mit einer Referenzabweichung.

## Beschreibung

Die vorliegende Erfindung betrifft ein Computer-implementiertes Verfahren, eine Computer-implementierte Vorrichtung, ein System sowie ein Computerprogrammprodukt zum Bestimmen eines Degradationsfortschritts eines Stromrichters und/oder eines elektrischen Antriebsmittels.

Elektrische Bauteile unterliegen im Allgemeinen einem Alterungsprozess. Diese können z.B. durch wiederholtes Erwärmen und Abkühlen der betreffenden Bauteile im Regelbetrieb verursacht werden, durch im Material der elektrischen Bauteile vorhandene Materialdefekte, etc. Dies Alterungsprozess führt zu einer in der Regel begrenzten Lebenszeit der betreffenden Bauteile, welche folglich nach einer gewissen Einsatzzeit ausgetauscht werden müssen.

In einigen Fällen können auch in elektrischen Antriebssystemen durch deren Benutzung eine Alterung auftreten. Diese Alterung kann z.B. durch eine Verringerung eines Rotorflusses durch eine Degradation von Magneten des elektrischen Antriebssystems und/oder eine Erhöhung des Widerstands einer Rotorwicklung auftreten. In einigen Fällen kann sich auch ein Übergangswiderstand an einer Kontaktstelle des Rotor (z.B. eines elektrisch leitenden Übergangs vom Stator hin zum Rotor) vergrößern. Diese Alterungseffekte können sich auf das Verhalten des elektrischen Antriebsmittels auswirken und damit auch auf die Eigenschaften der verwendeten Regelung, um z.B. sicherzustellen, dass einem elektrischen Antrieb stets eine gewünschte Versorgungsspannung bzw. ein gewünschter Versorgungsstrom zur Verfügung gestellt wird.

Die verbleibende Lebenszeit von Komponenten in einem zuvorgenannten System (z.B. in einem Stromrichter und/oder einem elektrischen Antriebsmittel) kann für einen Anlagenbetreiber häufig schwer zu ermitteln sein. Das Bestimmen einer zu verbleibenden Lebenszeit kann sowohl für einen Hersteller des jeweiligen elektrischen Bauteils als auch für einen Systemadministrator, welcher für eine Implementierung des jeweiligen elektrischen Bauteils zuständig ist, eine Herausforderung darstellen. Hersteller führen diesbezüglich häufig offline Berechnungen durch, um eine zu erwartete Lebenszeit eines Bauteils (z.B. eines Leistungswandlers) zu bestimmen und führen diese dann in ihren Dokumentationen auf. Diese Berechnungen basieren meist auf Lastprofilen und Produktnutzung, wie sie über einen idealen Produktzyklus hinweg auftreten kann, während typische Randbedingungen in Betracht gezogen werden, wie z.B. Temperatur, Feuchtigkeit, Höhe, etc.

Die Ermittlung der verbleibenden Lebenszeit kann z.B. durch eine regelmäßige Wartung der betreffenden Komponenten erfolgen. In einem derartigen Fall können z.B. zwei Wartungsstrategien in Frage kommen. Es ist ggf. möglich, basierend auf den bekannten Lastprofilen und spezifizierten Umgebungsbedingungen Wartungsintervalle festzulegen, zu deren Zeitpunkten die zu wartenden Komponenten mit hoher Wahrscheinlichkeit noch funktionstüchtig sind. Die Wahl dieser Wartungsintervalle kann jedoch häufig dazu führen, dass Komponenten mit ggf. noch beträchtlicher verbliebener Lebenszeit ausgetauscht werden, was zu (unnötig) hohen Kosten und Materialeinsatz führen kann.

Als weitere Wartungsstrategie, falls Stillstandzeiten des elektrischen Systems in Kauf genommen werden können, kann auch ein Austausch der betreffenden Komponente erfolgen, genau dann, wenn diese auch tatsächlich ausgefallen ist. Dies kann zwar die mit einem zu frühen Austausch verbundenen (unnötigen) Kosten verringern, jedoch kann demgegenüber ein unerwarteter Stillstand des elektrischen Systems erfolgen und dadurch z.B. eine Produktionslinie stilllegen. Je nach dadurch aufgetretenem Defekt kann dies zu unerwartet hohen Kosten führen. Die Auswahl, der für die betreffende Anlage und Applikation optimierten Wartungsintervalle kann zu einer globalen Kostenreduktion und zu einer Minimierung der Stillstandzeit des elektrischen Systems führen.

Durch den Einsatz sog. Condition Monitoring Verfahren kann der Zeitpunkt, wann eine Wartung des elektrischen Systems durchgeführt werden soll, optimiert werden, indem die verbliebene Lebenszeit der elektrischen Komponenten bzw. ein Fortschritt eines aktuellen Degradationsprozesses ermittelt wird.

Verfahren zum Condition Monitoring eines Systems im Zeitverlauf wurden z.B. durch die Verwendung geberloser Rotorlagenidentifikation getrieben, wobei häufig Testsignale eingesetzt wurden und eine Systemantwort im Betrieb aufgezeichnet wurde, wodurch dann auf möglicherweise auftretende Alterungsprozesse geschlossen werden konnte.

Allgemein kann das Condition Monitoring in drei unterschiedliche Klassen von Ansätzen unterteilt werden:
Im Rahmen der sensorbasierten Condition Monitoring Systeme kann zusätzliche/dedizierte Sensorik und/oder komplexe Messschaltungen verwendet werden, um direkt Größen eines elektrischen Systems zu messen, welche Rückschlüsse auf einen aktuellen Degradationsfortschritt elektrischer Komponenten ermöglichen. Die Komplexität und auch die Implementierungskosten eines derartigen Systems können dabei deutlich steigen. Unterschieden werden kann weiter zwischen Messsystemen, die online im Betrieb eines Stromrichtersystems eingesetzt werden und externer Prüftechnik, die lediglich in festgelegten (vorbestimmten) Intervallen zur Messung verwendet wird.

Im Rahmen modellbasierter Condition Monitoring Systeme wird versucht, einige der vorstehend genannten Probleme zumindest teilweise durch Modellbildung zu überwinden. In diesen Modellen wird der Alterungsvorgang physikalisch oder stochastisch implementiert. Das Modell wird anschließend online im Betrieb mit Lastprofilen und Umgebungsbedingungen als Eingangsvariablen betrieben. Das Ergebnis kann eine stochastische Bewertung der verbliebenen Lebenszeit bzw. des aktuellen Schweregrads der Schädigung sein. Trotz des Wegfalls zusätzlicher Messschaltungen besteht die Herausforderung dennoch in einem Modellaufbau mit ausreichender Güte.

Datenbasierte Condition Monitoring Systeme können derart eingerichtet sein, aus bestehenden Mess- und Zustandsgrößen Muster, die Rückschlüsse auf die Änderung eines Degradationsindikators ermöglichen und damit Rückschlüsse auf eine eingetretene Alterung ermöglichen. Hierbei kann der Informationsgehalt von verschiedenen möglichen Messsignalen und Zustandsgrößen analysiert werden sowie auf Möglichkeiten der Signalverarbeitung zurückgegriffen werden. Dies kann basierend auf statistischen Methoden erfolgen oder basierend auf Methoden der künstlichen Intelligenz.

Bekannte Condition Monitoring Verfahren ermöglichen jedoch noch nicht unter allen Umständen eine zufriedenstellende Bestimmung eines Degradationsfortschritts, da diese zu komplexe Hardware, eine zu komplexe Modellbildung oder eine aufwendige Datenanalyse erfordern. In einigen Fällen, sind derzeit verwendete Condition Monitoring Verfahren für den Feldeinsatz schlicht zu ungenau.

Es kann möglich sein, das Condition Monitoring eines Stromrichters, z.B. bei Vorliegen eines (elektrischen) Antriebs auf das Erfassen von mechanischen Vibrationen und/oder elektrischer Signale, welche mit dem Betrieb des Antriebs assoziiert sind, zu basieren. Eine Möglichkeit in diesem Zusammenhang kann der Rückgriff auf eine motor current signature analysis (MCSA) sein, welche z.B. angewendet wird, um mechanische Fehler eines Antriebs zu identifizieren, wie z.B. eine Fehlausrichtung, Ungleichgewicht, lockere Füße des Motors, Kavitationseffekte (z.B. bei Pumpen) etc. Dies stützt sich jedoch im Wesentlichen auf die Auswertung mechanischer Parameter und kann daher nicht in allen Fällen eine erwünschte Vorhersagegenauigkeit sicherstellen.

Es kann daher vorteilhaft sein, auf datenbasierte Condition Monitoring Verfahren zurückzugreifen, wobei sich hiebei die initiale Konfiguration eines Systems bzw. insbesondere die Definition eines initial als normal (bzw. fehlerfrei) anzusehenden Zustand häufig schwierig gestaltet. Durch eine Änderung des Systemaufbaus (z.B. durch Verwenden einer anderen elektrischen Last) oder Fertigungsstreuungen und Toleranzen ändert sich die meist die zugrundeliegende Parametrierung, das grundlegende Systemverhalten und darin vorkommende Zusammenhänge jedoch in der Regel nicht. Das Verfahren zur initialen Definition eines Normalzustands muss dabei also häufig auf die konkret verwendete Analge adaptiert werden. Je nach System und den Restriktionen durch die Last wird jedoch häufig auch die Zahl möglicher Betriebspunkte für die Initialisierung eingegrenzt, was die Definition eines initialen Zustands meist schwierig und auch ungenau gestaltet.

Eine derartige initiale Parametrierung, d.h. Festlegung eines initialen Zustands des betrachteten Systems, von datenbasierten Condition Monitoring Systemen erfolgt meistens innerhalb einer gewissen Zeit nach erstmaliger Implementierung des Systems. Diese Zeit, welche als Einlernphase verstanden werden kann, kann als eine Charakterisierung eines fehlerfreien Zustands des Systems angesehen werden. Hierbei können je nach Anwendungsfall, Online-Parameteridentifikationen, Parametrierungsläufe sowie ein Nachtrainieren von neuronalen Netzwerken zum Einsatz kommen. Das zugrundeliegende Verfahren kann dabei die Methoden definieren, welche für den Initialisierungsvorgang eingesetzt werden können. Bevorzugt wird die Einlernzeit so gewählt, dass das System noch sicher in einem ungealterten Zustand ist (d.h. einem fehlerfreien Zustand), jedoch auf der anderen Seite auch möglicherweise anfänglich notwendige Prozesse (z.B. ein Einschwingen von Parametern) bereits abgelaufen sind. Stehen genügend Daten von bisherigen Systemen zur Verfügung, kann das datenbasierte Condition Monitoring mit diesem bereits vorhandenen Datensatz initialisiert und letztlich trainiert (d.h. ein Referenzmodell bzgl. dessen ein Condition Monitoring ausgeführt werden soll) werden. Hierzu können statistische Methoden sowie Methoden aus dem Bereich des maschinellen Lernens zum Einsatz kommen. Wenn entsprechend erforderliche Daten nicht existieren, können die Daten durch eine Modellierung des Systems und anschließender Simulation generiert werden (z.B. durch ein Digital Twin Modell).

In einigen Fällen kann eine vermeindlichen Degradation eines elektrischen Bauteils auch durch Abweichungen einer initalen Parametrierung (d.h. einer Definition von Parametern des elektrischen Bauteils welche als normal bzw. gesund angesehen werden können) des Systems von einer realen Implementierung des Systems auftreten. Dies kann z.B. durch das Auftreten möglicher Fertigungstoleranzen und/oder Toleranzen in den Parametern der verwendeten Materialien erklärt werden, welche so in der initialen Parametrierung nicht immer in ausreichendem Umfang abgebildet werden können, was eine finale Bestimmung eines Degradationszustands eines elektrischen Bauteils häufig schwierig und ungenau machen kann.

Es besteht daher ein Bedarf ein verbessertes Condition Monitoring Verfahren bereitzustellen, welches die Nachteile und Einschränkungen derzeit verwendeter Condition Monitoring Verfahren zumindest teilweise überwindet.

Die vorliegende Erfindung stellt sich daher die technische Aufgabe ein verbessertes und leicht bzw. kostengünstig zu implementierendes Condition Monitoring Verfahren bereitzustellen, welches insbesondere eine effizientere Parametetrierung ermöglicht.

Dies wird erreicht durch einen ersten Aspekt der Erfindung, welcher sich auf ein Computer-implementiertes Verfahren zum Bestimmen eines Degradationsfortschritts eines Stromrichters und/oder eines elektrischen Antriebsmittels bezieht. Das Computer-implementierte Verfahren kann ein Erfassen eines zeitlichen Verlaufs einer initialen mit einer Reglung einer Ausgangsspannung und/oder einem Ausgangsstrom des Stromrichters assoziierten zumindest einen Zustandsgröße, wobei die Ausgangsspannung und/oder der Ausgangsstrom zur Zuführung an das elektrische Antriebsmittel bestimmt ist, umfassen. Ferner kann das Computer-implementierte Verfahren ein Erfassen eines zeitlichen Verlaufs der zumindest einen Zustandsgröße zu einem späteren, von einem mit der initialen Zustandsgröße assoziierten, verschiedenem Zeitpunkt sowie ein Bestimmen, ob eine Abweichung eines mit dem erfassten zeitlichen Verlaufs der Zustandsgröße zu dem späteren Zeitpunkt assoziierten Wertes von einem mit dem erfassten zeitlichen Verlaufs der initialen Zustandsgröße assoziierten Werts eingetreten ist, umfassen. Ferner kann das Computer-implementierte Verfahren ein Bestimmen, falls eine Abweichung bestimmt wurde, einer mit einer Degradation des Stromrichters assoziierten Zeitkonstante mit welcher die Abweichung eingetreten ist sowie ein Bestimmen, zumindest teilweise basierend auf der Zeitkonstante, einer Degradationsursache und eines Degradationsfortschritts, zumindest teilweise basierend auf einem Vergleichen der bestimmten Abweichung mit einer Referenzabweichung, umfassen.

Unter einem Degradationsfortschritt kann vorliegend ein Voranschreiten eines Alterungsprozesses des Stromrichters (hierin auch als Umrichter bezeichnet) und/oder des elektrischen Antriebsmittels verstanden werden. Ein Voranschreiten der Degradation kann mit einer ansteigenden Ausfallwahrscheinlichkeit des Stromrichters und/oder des elektrischen Antriebsmittels (z.B. durch einen Defekt) assoziiert sein. Der zeitliche Verlauf kann zu vorbestimmten (diskreten) Zeitpunkten erfasst werden und/oder kann kontinuierlich während des Betriebs des Stromrichters und/oder des elektrischen Antriebsmittels erfasst werden.

Der erfasste zeitliche Verlauf kann sich über eine Dauer von weniger als einer Sekunde erstrecken. In einigen Fällen kann such der erfasste zeitliche Verlauf über eine Sekunde bis zehn Sekunden erstrecken, in einigen Fällen über eine Dauer von elf Sekunden bis 30 Sekunden, in weiteren Fällen über eine Dauer von 31 Sekunden bis zu 60 Sekunden. In weiteren Fällen kann sich die Dauer auch über mehrere Minuten erstrecken (z.B., zwei, drei, vier, fünf, zehn, 15, 20, 25, 30, 35, 40, 45, 50, 55 Minuten). Es kann hingegen auch möglich sein, dass sich der zeitliche Verlauf über eine Dauer von mehr als einer Stunde erstreckt oder über mehrere Tage hinweg.

Unter einer initialen Zustandsgröße kann vorliegend eine Zustandsgröße verstanden werden, welche mit einem Zustand des Stromrichters und/oder des elektrischen Antriebsmittels unmittelbar nach einer initialien Betriebsaufnahme, d.h. nach einer erstmaligen Implementierung, verknüpft ist. Die initiale Zustandsgröße kann mit einem Zeitpunkt des Stromrichters und/oder des elektrischen Antriebsmittels assoziiert sein, zu welchem der Stromrichter und/oder das elektrischen Antriebsmittel erstmalig den für den Stromrichter und/oder das elektrische Antriebsmittel angedachten Normalbetrieb (d.h. nach einer initialen Konfiguration) aufnimmmt.

Die Referenzabwichung kann durch Vergleichen einer Amplitude der bestimmten Abweichung mit einer Referenzamplitude ermöglicht werden. Die Referenzamplitude kann auf einem vorangegangenen Bestimmen eines Degradationsfortschritts eines (baugleichen) Stromrichters und/oder elektrischen Antriebsmittels und einer damit einhergehenden Amplitude der zumidnest einen Zustandsgröße basieren. In einigen Fällen kann die Referenzamplitude aus einem vorangegangenen, systematischen Abbilden von unterschiedlichen Degradationsfortschritten für (baugleiche) Stromrichter und/oder elektrische Antriebsmittel basierend auf entsprechenden Amplituden hervorgehen. In einigen Fällen, kann die Referenzamplitude zumindest teilweise durch Verwenden eines neuronalen Netzes bestimmt werden (z.B. in dem dieses eine Referenzamplitude bestimmt, bei deren Erreichen mit einer vorbestimmten Wahrscheinlichkeit z.B. ein Ausfall des Stromrichters und/oder des elektrischen Antriebsmittels anzunehmen ist).

In einigen Fällen kann das Bestimmen eines Degradationsfortschritts nicht nur als eine absolute Feststellung (nämlich, dass eine Degradation eingetreten ist) erfolgen, sondern insbesondere kann auch eine z.B. stufenweise Feststellung erfolgen, wie weit der Degradationsfortschritt bereits fortgeschritten ist. Auf diese Weise kann z.B. eine Aussage dahingehend erfolgen, dass der Stromrichter z.B. 10 %, 20 %, 30 %, 40 %, 50 %, 60 %, 70 %, 80 %, 90 %, 99 % seiner erwarteten Lebenszeit bereits erreicht hat, was als Ausgangspunkt dafür benutzt werden kann zu entscheiden, ob ein Austausch des Stromrichters erfolgen soll.

Die Zeitkonstante kann sich auf eine Ableitung der betrachteten Zustandsgröße beziehen. Die Zeitkonstante kann so angeben, um z.B. wie viele Prozentpunkte (relativ zu einem Wert einer initialen Zustandsgröße) pro Zeiteinheit eine Veränderung der Zuständsgröße (wie zu einem späteren Zeitpunkt, von dem Zeitpunkt, zu welchem der Wert der initialen Zustandsgröße erfasst wurde, verschieden) eingetreten ist.

Die Abweichung kann aus einer Zunahme eines Durchschnittswerts, welcher aus dem erfassten zeitlichen Verlauf der Zustandsgröße zu dem späteren Zeitpunkt gewonnen werden kann, relativ zu einem Durchschnittswerts welcher aus dem erfassten zeitlichen Verlauf der initialen Zustandsgröße gewonnnen werden kann, hervorgehen.

In einigen Fällen kann der bestimmte Degradationsfortschritt einem Benutzer des Stromrichters und/oder des elektrischen Antriebsmittels über eine Benutzerschnittstelle (z.B. ein Display, ein Tablet, eine gesprochene Aussage, etc.) bereitgestellt werden.

Das Computer-implementierte Verfahren kann insbesondere ohne die Verwendung weiterer, im Normalbetrieb des Stromrichters per se nicht verwendeter Sensoren ausgeführt werden. Auf diese Weise kann das Computer-implementierte Verfahren auch für das datenbasierte Condition Monitoring von bereits ausgelieferten Stromrichtern (z.B. durch ein Softwareupdate) kostengünstig nachgerüstet werden. Des Weiteren ist es möglich, neu hergestellte Stromrichter mit dem Computer-implementierten Verfahren ohne zusätzlichen Kostenaufwand auszustatten, da keine für das Computer-implementierte Verfahren dedizierte Messelektronik erforderlich ist. Somit kann ein kostengünstiges Condition Monitoring Verfahren weiter unterstützt werden. Insbesondere kann das Bestimmen eines Degradationsfortschritts somit basierend auf Prozessparametern erfolgen, welche bereits während des Betriebs des Stromrichters anfallen und nicht mehr dediziert im Rahmen des Computer-implementierten Verfahrens erzeugt werden müssen. Somit werden etwaige im Speziellen zu erzeugende Überwachungssignale entbehrlich, was sich auf eine Komplexitätsreduktion des zu überwachenden Stromrichters auswirken kann. Dies kann auch die Verwendung ggf. ansonsten erforderlicher Testsignale, welche z.B. in den Stromrichter und/oder das elektrische Antriebsmittel eingebracht werden und deren Veränderung als Indiaktor gemssen werden würde, als obsolet erscheinen lassen. Auf diese Weise kann ein vereinfachtes, kostengünstiges Überwachen des Degradationsfortschritts ermöglicht werden.

Gemäß einer Ausführungsform kann die mit der Regelung assoziierte zumindest eine Zustandsgröße ein I-Anteil eines PI-Reglers, ein P-Anteil eines PI-Reglers, ein Ausgabewert eines Fehlerspeichers, ein Ausgabewert einer Vorsteuerung und/oder ein Zwischenergebnis sein.

Der I-Anteil und/oder der P-Anteil eines betreffenden PI-Reglers kann so bereitgestellt werden, dass sich dieser jeweils aus einer Multiplikation eines Fehlersignals (d.h. einer Differenz zwischen einer Soll-Größe und einer Ist-Größe der Ausgangsspannung und/oder des Ausgangsstroms) mit einem vorbestimmten P- oder I-Wert ergibt. Bei dem P- oder I-Wert handelt es sich bevorzugt um ein Skalar. In einigen Fällen, kann die mit der Regelung assoziierte zumindest eine Zustandsgröße auch aus einer Summe des I-Anteils und des P-Anteils hervorgehen.

Der Ausgabewert des Fehlerspeichers kann mit einem Repetitive Control Reglers assoziiert sein. Das Konzept eines Repetitive Control Reglers kann darauf basieren, dass für eine bestimmte Differenz zwischen Soll-Wert und Ist-Wert (und/oder für eine bestimmte Steigung des zu regelnden Signals) bereits bekannt ist, welche Regelungsgröße (z.B. welche Stellspannung) verwendet werden kann, um die bestimmte Differenz zu minimieren bzw. zu Nullen. Auf diese Weise kann auch für höherfrequente Signalkomponenten, welche z.B. durch den I-Anteil einer PI-Regelung (z.B. auf Grund dessen integrierenden Verhaltens) nicht ausreichend ausgeregelt werden können, eine ausreichende Regelung ermöglicht werden kann.

Auf diese Weise kann basierend auf der zumindest einen Zustandsgröße nicht nur ein Bestimmen eines Degradationsfortschritts des Stromrichters erfolgen (da so z.B. eine Abweichung in der Ausgangsspannung und/oder dem Ausgangsstrom bestimmt werden kann), welche durch eine PI-Regler und/oder Fehlerspeicher-basierte Regelung bis zu einem gewissen Degradationsfortschritt ausgeregelt bzw. kompensiert werden kann, sondern zusätzlich oder alternativ auch ein Degradationsfortschritt des elektrischen Antriebsmittels selbst bestimmt werden kann. Dies kann dadurch erreicht werden, dass sich bei Voranschreiten des Degradationsfortschritts des elektrischen Antriebsmittels, dessen Eingangsstrom- bzw. dessen Eingangsspannung verändern kann, was entsprechend durch den (vorgeschalteten) Stromrichter bis zum einem gewissen Degradationsfortschritt des elektrischen Antriebsmittels kompensiert werden kann (z.B. durch Anpassen des Ausgangangsstroms und/oder der Ausgangsspannung des Stromrichters, so dass eine erforderliche respektive Eingangsspannung bzw. ein respektiver Eingangsstrom am elektrischen Antriebsmittel bereitgestellt werden kann).

Unter einem Zwischenergebnis können vorliegend alle verfügbaren Messgrößen und ableitbare Größen der Regelung verstanden werden. Es können beispielsweise auch die transformierten gemessenen Ströme oder die Reglersollspannungen im αβ-System sein als Zwischenergebnis verstanden werden.

Auf diese Weise kann das Condition Monitoring, neben dem Bestimmen eines Degradationsfortschritts des Stromrichters auf ein Bestimmen des Degradationsfortschritts des elektrischen Antriebsmittels erweitert werden. Somit kann insgesamt ein verbessertes Condition Monitoring ermöglicht werden, ohne eine Zunahme der Systemkomplexizät in Kauf nehmen zu müssen.

Gemäß einer weiteren Ausführungsform kann das Bestimmen der Degradationsursache ferner ein Bestimmen umfassen, dass die Abweichung über einen Zeitraum von zumindest einem Monat aufgetreten ist und basierend darauf mit einer Alterung des Stromrichters assoziiert werden kann oder ein Bestimmen, dass die Abweichung über einen Zeitraum von mindestens einer Minute und weniger als einem Tag aufgetreten ist und basierend darauf mit einer Temperaturveränderung des Stromrichters assoziiert werden kann oder ein ein Bestimmen, dass die Abweichung über einen Zeitraum von weniger als einer Minute aufgetreten ist und basierend darauf mit Lastsprüngen assoziiert werden kann.

Auf diese Weise kann auf Basis des Bestimmens einer Zeitkonstante, d.h. durch Bestimmen der Geschwindigkeit (im Sinne einer Änderungsrate) mit welcher sich z.B. ein mit dem erfassten zeitlichen Verlauf der Zustandsgröße zu einem späteren Zeitpunkt assozierter Wert ändert, letztlich auf die Geschwindigkeit der Änderung der Zustandsgröße geschlossen werden.

In einigen Fällen, kann die Zeitkonstante zusätzlich oder alternativ dazu benutzt werden, eine Temperatur in dem Stromrichter und/oder dem elektrischen Antriebsmittel zu bestimmen, wobei die Zeitkonstante mit einer Änderung der Zustandsgröße basierend auf einer Zeitbasis von Minuten oder Stunden assoziiert ist.

Unter Lastsprüngen kann vorliegend eine (sprunghafte) Veränderung von Strömen, Spanneungen und/oder Leistung verstanden werden.

Da verschiedene Degradationsursachen mit unterschiedlichen Zeitsaklen ablaufen (d.h. mit unterschiedlichen Änderungsraten assoziiert sind), kann auf effiziente Weise auf eine Degradationsursache geschlossen werden, ohne auf weitere Sensorik und/oder eine dedizierte Erfassung von spezifischen Messgrößen zurückgreifen zu müssen.

Gemäß einer weiteren Ausführungsform kann das Bestimmen, ob eine Abweichung eingetreten ist ferner ein Bestimmen einer Differenz zwischen dem Wert der initialen Zustandsgröße und dem Wert der Zustandsgröße zu dem späteren Zeitpunkt umfassen und/oder ein Bestimmen einer Differenz einer Amplituden einer höhereren Harmonischen der initialen Zustandsgröße und einer Amplitude einer höheren Harmonische der Zustandsgröße zu einem späteren Zeitpunkt.

In einigen Fällen kann der Wert der initialen Zustandsgröße und/oder der Wert der Zustandsgröße zu dem späteren Zeitpunkt durch ein Mitteln des entsprechenden zeitlichen Verlaufs der Zustandsgrößen erhalten werden. In einigen Fällen kann das Mitteln ein Bilden eines arithmetischen Mittels über erfasste einzelne Messungen (im Rahmen des zeitlichen Verlaufs) erhalten werden.

In einigen Fällen kann das Bestimmen einer Differenz einer Amplituden einer höheren Harmonischen der initialen Zustandsgröße und der Amplitude der höheren Harmonischen der Zustandsgröße zu dem späteren Zeitpunkt ein vorgelagertes Fourier-Transformieren (z.B. zumindest teilweise basierend auf einer Fast Fourier Transform (FFT)) der jeweiligen dazugehörigen erfassten zeitlichen Verläufe umfassen.

Somit kann in effizienter Weise ein Bestimmen einer Abweichung des Werts der Zustandsgröße zu einem späteren Zeitpunkt relativ zum Wert der initialen Zustandsgröße sowohl in einer Zeitdomäne als auch (zusätzlich oder alternativ) in einer Frequenzdomäne ermöglicht werden. Insbesondere kann so das Bestimmen, ob ein Degradationsfortschritt vorliegt, nicht nur auf in der Zeitdomäne sichtbare Artefakte gestützt werden, sondern auch auf ein Auftreten dieser in der Frequenzdomäne zurückgegriffen werden.

Gemäß einer weiteren Ausführungsform kann das Erfassen des zeitlichen Verlaufs der initialen Zustandsgröße ein Erfassen des zeitlichen Verlaufs der initialen Zustandsgröße zumindest teilweise basierend auf einem Resultat einer Simulation des Stromrichters und/oder des elektrischen Antriebsmittels mittels eines Digital Twin Models umfassen.

In einigen Fällen können die mit der zumindest einen initialen Zustandsgröße assoziierten Werte durch eine Simulation gewonnen werden. Das Digital Twin Model kann derart bereitgestellt werden, dass es ein Verhalten des Stromrichters und/oder des elektrischen Antriebsmittels abbildet und simuliert.

Das Digital Twin Model kann das erwartete Verhalten des Systems inklusive Restriktionen des Betriebsbereichs durch eine verwendete Last abbilden.

Das Digital Twin Model kann zumindest einen Eingangsparameter vorsehen, welcher auch als zumindest ein Eingangsparameter mit dem Stromrichter und/oder dem elektrischen Antriebsmittel assoziiert ist. Zusätzlich oder alternativ kann das Digital Twin Model zumindest einen Ausgabeparameter vorgesehen, welcher auch als zumindest ein Ausgabeparameter mit dem Stromrichter und/oder dem elektrischen Antriebsmittel assoziiert ist.

In einigen Fällen kann das Erfassen des zeitlichen Verlaufs der initialen Zustandsgröße nach einem werksseitig initierten Festlegens eines zeitlichen Verlaufs der iniitalen Zustandsgröße erfolgen. In einem derartigen Fall kann das Erfassen des zeitlichen Verlaufs der initialen Zustandsgröße basierend auf dem Digital Twin Model als ein Update des herstellerseitigen Festlegens des zeitlichen Verlaufs der initialen Zustandsgröße verstanden werden.

Das Verwenden des Digital Twin Models kann die anfänglich erforderliche Parametrierungszeit, nach Implementierung des Stromrichters und/odes des elektrischen Antriebsmittels, verkürzen und damit zu einer insgesamt schnelleren Implementierung beitragen. In einigen Fällen, kann somit die initiale Zustandsgröße bereits auch vor Implementierung des Stromrichters und/oder des elektrischen Antriebsmittels erfolgen was ebenfalls zu einer effizienteren Implementierung beitragen kann. Ferner, kann durch die Digital Twin Modell-basierte initiale Parametrierung ein Blockieren des zu parametrierenden Stromrichters und/oder elektrischen Antriebsmittels unterbunden werden und damit damit ggf. damit einhergehende Opportunitätskosten minimiert werden. Insbesondere ermöglicht die Verwendung eines Digital Twin Models das Bereitstellen des zeitlichen Verlaufs der zumindest einen initialen Zustandsgröße für verschiedene Lasten und damit eine gezieltere Anpassung an die realen Verhältnisse des Stromrichters und/oder des elektrischen Antriebsmittels.

Gemäß einer weiteren Ausführungsform kann das Resultat der Simulation mit einem Gleichanteil und/oder einer höheren Harmonischen, bevorzugt einer 1., 2. oder 6. Harmonischen, eines zeitlichen Verlaufs der Ausgangsspannung und/oder des Ausgangsstroms assoziiert sein.

Neben diesen Parametern kann es auch möglich sein, im Rahmen der Simulation Betriebspunkte (d.h. Betriebsparameter des Stromrichters und/oder des elektrischen Antriebsmittels) zu identifizieren, die eine Relevanz hinsichtlich des Bestimmens der initialen Zustandsgrößen ermöglichen.

Auf diese Weise kann gezielt ein mit dem zeitlichen Verlauf der initialen Zustandsgröße assoziierter Wert generiert werden und später als Referenzgröße zur Berechnung einer Abweichung verwendet werden. Insbesondere ermöglicht die Verwendung eines Digital Twin Models eine effiziente Unterdrückung eines möglichen Einflusses durch Fertigungstoleranzen und/oder Parameterschwankungen der verwendeten Materialien des Stromrichters und/oder des elektrischen Antriebsmittels. Auf diese Weise kann der Initialzustand der Zustandsgröße präziser bestimmt werden.

Gemäß einer weiteren Ausführungsform kann der erfasste zeitliche Verlauf der initialen Zustandsgröße zumindest teilweise auf einer Leerlaufmessung des elektrischen Antriebs bei variabler oder fester elektrischer Frequenz basieren oder auf einer Messung von Betriebspunkten mit einem nicht-rotierenden Rotor des elektrischen Antriebs.

Ein nicht-rotierender Rotor kann auch als festgebremster Rotor verstanden werden.

Auf diese Weise kann es ermöglicht werden, unter verschiedenen Randbedingungen, ein Erfassen des zeitlichen Verlaufs der initialen Zustandsgröße vorzunehmen.

Gemäß einer weiteren Ausführungsform kann das Erfassen des zeitlichen Verlaufs der initialen Zustandsgröße auf einem Resultat der Simulation basieren und mittels der Leerlaufmessung oder der Messung von Betriebspunkten weiter an ein reales System angepasst werden.

Unter einer Leerlaufmessung kann vorliegend ein Betreiben des elektrischen Antriebsmittels ohne Last verstanden werden.

Unter einem Betriebspunkt kann vorliegend zumindest ein (bevorzugt mehrere) Parameter verstanden werden, welcher einen gegenwärtigen Betrieb eines Stromrichters und/oder eines elektrischen Antriebsmittels beschreibt.

Die Simulation basierend auf einer Leerlaufmessung und/oder Messung von Betriebspunkten kann ein Setzen der verscheidenen Randbedingungen (wie oben beschrieben) ermöglichen.

Unter einem Anpassen kann in diesem Zusammenhang ein "Fine-Tuning" des breits basierend auf dem Digital Twin Model erhaltenen mit dem erfassten zeitlichen Verlauf des initialen Zustands assoziierten Werts verstanden werden.

Auf diese Weise kann der ggf. zunächst "künstlich" erzeugte mit der initialen Zustandsgröße assoziierte Werte weiter an die tatsächlichen Gegebenheiten eines real vorhandenen Systems (d.h. an den realen Stromrichter und/oder das reale elektrische Antriebsmittel) angepasst werden. Dies kann schließlich einen genaueren Zuschnitt einer initialen Parametrierung (d.h. eines Bestimmens eines Werts der initialen Zustandsgröße) ermöglichen.

Gemäß einer weiteren Ausführungsform kann der zeitliche Verlauf der initialen Zustandsgröße mit einem fehlerfreien Zustand des Stromrichters assoziiert sein.

Auf diese Weise kann durch die initiale Zustandsgröße eine Referenzgröße bereitgestellt werden (welche mit einem als "gesund" anzusehenden Zustand des Stromrichters und/oder des elektrischen Antriebsmittels verstanden werden kann), basierend auf welcher auf eine Degradationsursuach und/oder einen Degradationsfortschritt geschlossen werden kann.

Gemäß einer weiteren Ausführungsform kann das Computer-implementierte Verfahren ferner ein Nachführen, zumindest teilweise basierend auf dem bestimmten Degradationsfortschritts, eines Reglers umfassen, um die Ausgangsspannung und/oder den Ausgangsstrom auf einen vorbestimmten Wert zu regeln.

Auf diese Weise kann es ermöglicht werden, einem Voranschreiten der Degradation des Stromrichters und/oder des elektrischen Antriebsmittels in effizienter Weise entgegenzuwirken. Ferner kann dies ermöglichen, iterativ die zumindest eine initiale Zustandsgröße im Zeitverlauf anzupassen, so dass der erfasste zeitliche Verlauf der zumindest einen initialien Zustandsgröße im Zeitverlauf angepasst werden kann. Auf diese Weise kann in einigen Fällen, auch wenn bereits eine Degradation des Stromrichters und/oder des elektrischen Antriebsmittels eingetreten ist, die zumindest eine initiale Zustandsgröße diese breits eingetretene (aber noch nicht als wesentlich anzusehende) Degradation berücksichtigen, z.B., dann, wenn zwar eine Degradation vorliegt, diese aber noch keinen Austausch des Stromrichters und/oder des elektrischen Antriebsmittels erfordert.

Gemäß einer weiteren Ausführungsform kann der Stromrichter ein 3-phasiger 2-Level Wechselrichter sein, wobei der Stromrichter zumindest ein Halbleitermodul, bevorzugt sechs Halbleitermodule umfasst und wobei das zumindest eine Halbleitermodul bevorzugt ein Bipolartransistor mit isolierter Gate Elektrode, IGBT, oder ein SiC- metal-oxide-semiconductor field-effect transistor, MOSFET, ist.

In einigen Fällen kann der Stromrichter ein Halbleitermodul, zwei, drei, vier, fünf, sechs, sieben, acht, neun, zehn oder mehr Halbleitermodule umfassen.

Es sei angemerkt, dass die hierin genannten Aspekte der Erfindung nicht auf IGBTs oder MOSFETs als Halbleitermodule beschränkt sind, sondern dass Aspekte der Erfindung auch auf andere Halbleitermodule, welche hierin nicht explizit beschrieben werden, angewandt werden können.

In einigen Fällen kann der Stromrichter als eine Drehstrombrückenschaltung bereitgestellt werden.

Dies kann eine besonders kompakte und kostengünstige Implementierung eines Stromrichters ermöglichen

Gemäß eines zweiten Aspekts wird ein Computerprogrammprodukt vorgeschlagen, umfassend Befehle, die bei der Ausführung des Programms durch einen Computer diesen veranlassen, das Verfahren nach einem der herin genannten Ausführungsformen auszuführen.

In einigen Fällen kann das Computerprogrammprodukt z.B. in eine Antriebssteuerungssoftware des elektrischen Mittels integriert werden. In einigen Fällen können zumindest auszuführende Rechenoperationen (z.B. das Bestimmen der Abweichung und/oder einer Degradationsursache und/oder einees Degradationfortschritts) von einer vom Stromrichter und/oder vom elektrischen Antriebsmittel getrennten Entität (z.B. eines Serversystems) getrennt sein. Auf diese Weise können ggf. rechenintensive Operationen von einer dediziert verwendeten Hardware ausgeführt werden.

Ein Computerprogrammprodukt, wie z.B. ein Computer-programm-Mittel, kann beispielsweise als Speichermedium, wie z.B. Speicherkarte, USB-Stick, CD-ROM, DVD, oder auch in Form einer herunterladbaren Datei von einem Server in einem Netzwerk bereitgestellt oder geliefert werden. Dies kann zum Beispiel in einem drahtlosen Kommunikationsnetzwerk durch die Übertragung einer entsprechenden Datei mit dem Computerprogrammprodukt oder dem Computerprogramm-Mittel erfolgen.

Gemäß eines dritten Aspekts wird eine Computer-implementierte Vorrichtung zum Bestimmen eines Degradationsfortschritts eines Stromrichters und/oder eines elektrischen Antriebsmittels vorgeschlagen. Die Computer-implementierte Vorrichtung kann eine erste Erfassungseinheit zum Erfassen eines zeitlichen Verlaufs einer initialen mit einer Reglung einer Ausgangsspannung und/oder einem Ausgangsstrom des Stromrichters assoziierten zumindest einen Zustandsgröße, wobei die Ausgangsspannung und/oder der Ausgangsstrom zur Zuführung an das elektrisches Antriebsmittel bestimmt ist und eine zweite Erfassungseinheit zum Erfassen eines zeitlichen Verlaufs der zumindest einen Zustandsgröße zu einem späteren, von einem mit der initialen Zustandsgröße assoziierten, verschiedenem Zeitpunkt umfassen. Ferner kann die Computer-implementierte Vorrichtung eine erste Bestimmungseinheit zum Bestimmen, ob eine Abweichung eines mit dem erfassten zeitlichen Verlaufs zu dem späteren Zeitpunkt assoziierten Wertes von einem mit dem erfassten zeitlichen Verlaufs der initialen Zustandsgröße assoziierten Werts eingetreten ist und eine zweite Bestimmungseinheit zum Bestimmen, falls eine Abweichung bestimmt wurde, einer mit einer Degradation des Stromrichters assoziierten Zeitkonstante mit welcher die Abweichung eingetreten ist umfassen. Ferner kann die Computer-implementierte Vorrichtung eine dritte Bestimmungseinheit zum Bestimmen, zumindest teilweise basierend auf der Zeitkonstanten, einer Degradationsursache und eines Degradationsfortschritts, zumindest teilweise basierend auf einem Vergleichen der bestimmten Abweichung mit einer Referenzabweichung, umfassen.

Die jeweilige Einheit, zum Beispiel jede der Erfassungseinheiten und der Bestimmungseinheiten, kann hardwaretechnisch und/oder auch softwaretechnisch implementiert sein. Bei einer hardwaretechnischen Implementierung kann die jeweilige Einheit als Vorrichtung oder als Teil einer Vorrichtung, zum Beispiel als Computer oder als Mikroprozessor oder als Steuerrechner eines Fahrzeuges ausgebildet sein. Bei einer softwaretechnischen Implementierung kann die jeweilige Einheit als Computerprogrammprodukt, als eine Funktion, als eine Routine, als Teil eines Programmcodes oder als ausführbares Objekt ausgebildet sein.

Gemäß einer Ausfürhungsform kann die Computer-implementierte Vorrichtung ferner eine Ausführungseinheit zum Ausführen des Computerprogrammprodukts wie hierin beschrieben sowie eine weitere Ausführungseinheit zum Ausführen des Verfahrens nach einer der Ausführungsformen, wie hierin beschrieben, umfassen.

Die Ausführungseinheit kann z.B. als Computer, Prozessor, Field Programmable Gate Array (FPGA) oder eine Kombination davon vorgesehen sein.

Gemäß eines vierten Aspekts wird einSystem zum Bestimmen eines Degradationsfortschritts eines Stromrichters vorgeschlagen. Das System kann ein Computerprogrammprodukt umfassen, wie hierin beschrieben, und/oder die Computer-implementierte Vorrichtung, wie ebenfalls hierin beschrieben.

Das Computerprogrammprodukt kann in der Computer-implementierten Vorrichtung enthalten sein. In alternativen Beispielen kann das Computerprogramm auch in einer von der Computer-implementierten Vorrichtung entfernt vorgehaltenen Einheit enthalten sein. In letzterem beispielhaft genannten Fall kann die Computer-implementierte Vorrichtung über ein Netzwerk (z.B. ein lokales Netzwerk oder das Internet) oder eine USB-Verbindung auf das Computerprogrammprodukt zugreifen.

Die für die vorgeschlagene Vorrichtung beschriebenen Ausführungsformen und Merkmale gelten für das vorgeschlagene Verfahren entsprechend.

Weitere mögliche Implementierungen der Erfindung umfassen auch nicht explizit genannte Kombinationen von zuvor oder im Folgenden bezüglich der Ausführungsbeispiele beschriebenen Merkmale oder Ausführungsformen. Dabei wird der Fachmann auch Einzelaspekte als Verbesserungen oder Ergänzungen zu der jeweiligen Grundform der Erfindung hinzufügen.

Weitere vorteilhafte Ausgestaltungen und Aspekte der Erfindung sind Gegenstand der Unteransprüche sowie der im Folgenden beschriebenen Ausführungsbeispiele der Erfindung. Im Weiteren wird die Erfindung anhand von bevorzugten Ausführungsformen unter Bezugnahme auf die beigelegten Figuren näher erläutert.

Insbesondere sei angemerkt, dass das oben beschriebene Verfahren bzw. die oben beschriebene Vorrichtung, das oben beschriebene Computerprogrammprodukt sowie das System nicht auf Stromrichter und/oder elektrische Antriebsmittel beschränkt ist, sondern auch in anderen industriellen Kontexten Anwendung finden kann.

Weitere vorteilhafte Ausgestaltungen und Aspekte der Erfindung sind Gegenstand der Unteransprüche sowie der im Folgenden beschriebenen Ausführungsbeispiele der Erfindung. Im Weiteren wird die Erfindung anhand von bevorzugten Ausführungsformen unter Bezugnahme auf die beigelegten Figuren näher erläutert.
- Fign. 1A-1C: zeigen einen Querschnitt durch einen IGBT (Fig. 1A) sowie mögliche Degradationsursachen eines Stromrichters (Fign. 1B und 1C);
- Fig. 2: zeigt ein exemplarisches System, welches ein Zusammenwirken eines Stromrichters in einem möglichen erfindungsgemäßen Kontext zeigt;
- Fig. 3: zeigt ein exemplarisches Ersatzschaltbild einer Drehstrombrückenschaltung;
- Fig. 4: zeigt ein exemplarisches αβ-Diagramm;
- Fig. 5: zeigt einen exemplarischen Systemflussplan gemäß Aspekten der vorliegenden Erfindung;
- Fign. 6A und 6B: zeigen exemplarische Simulationen von Zustandsgrößen im Rahmen eines Digital Twin Models;
- Fig. 7: zeigt eine exemlarische Implementierung eines Stromrichters;
- Fig. 8: zeigt ein Ablaufdiagramm eines exemplarischen Computer-implementierten Verfahrens;
- Fig. 9: zeigt eine exemplarische Computer-implementierte Vorrichtung; und
- Fig. 10: zeigt ein exemplarisches System zum Bestimmen eines Degradationsfortschritts.

In den Figuren sind gleiche oder funktionsgleiche Elemente mit denselben Bezugszeichen versehen worden, sofern nichts anderes angegeben ist.

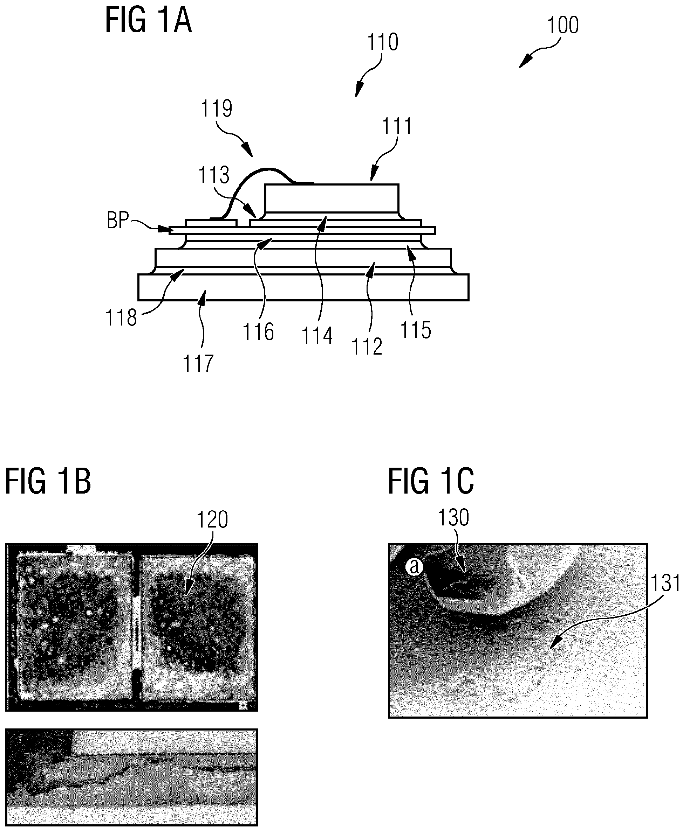

Fig. 1 zeigt einen exemplarischen Querschnitt durch einen IGBT 110, wie dieser z.B. in einem Stromrichter bzw. Umwandler enthalten sein kann.

IGBT besteht aus einem Chip 111, welcher auf einer Basisplatte 112 angeordnet ist. Zwischen dem Chip 111 und der Basisplatte 112 kann eine erste Kupferschicht 113 angeordnet sein, um eine optimale Wärmeleitung zwischen dem Chip 111 und der Basisplatte 112 zu ermöglichen.

Chip 111 kann durch eine erste Lötzinnschicht 114 an der Kupferschicht 113 angebracht sein. Ferner kann die Basisplatte 112 über eine zweite Lötzinnschicht 115 und eine zweite Kupferschicht 116 mit der ersten Kupferschicht 113 verbunden sein.

Ferner kann zwischen der ersten Kupferschicht 113 und der zweiten Kupferschicht 116 eine (kleinere) Basisplatte vorgesehen sein.

Basisplatte 112 kann oberhalb einer Kühlplatte 117 angeordnet sein. Zwischen der Basisplatte 112 und der Kühlplatte 117 kann eine Wärmeleitpasteschicht 118 vorgesehen sein.

Ferner kann eine Oberseite des Chips 111 über einen Bonddraht 119 mit einer Stromversorgung (in Fig. 1 nicht abgebildet) verbunden sein.

Fig. 1B zeigt ferner eine mögliche Degradation eines Stromrichters (Ciappa, M.: "Selected failure mechanisms of modern power modules", Microelectronics Reliability, Vol. 42, Issues 4-5, 2002), welche z.B. durch eine Degradation einer Lötverbindung 120 hervorgerufen werden kann. Derartige Fehler in Lötverbindungen können z.B. durch (thermische) Risse im Lot hervorgerufen werden und/oder durch eine Ablösung der Lötverbindung (z.B. auch durch ein Ablösen eines Bonddrahts von der Oberseite des Chips 112 oder einer Stromversorgung). Eine Degradation einer Lötverbindung kann zu einer schlechteren elektrischen Kontaktierung führen und damit zu einer schlechteren Übertragung elektrischer Energie zum Betrieb von z.B. einem IGBT 110. Dies kann ferner zu einer Erhöhung des thermischen Widerstands führen und damit zu einer Änderung einer Durchlassspannung des IGBT was zu einer unerwünschten Erwärmung des IGBT führen kann und damit eine Degradation des IGBT 110 weiter vorantreiben kann.

Fig. 1C zeigt eine weitere mögliche Degradation des Umrichters (Ciappa, M.: "Selected failure mechanisms of modern power modules", Microelectronics Reliability, Vol. 42, Issues 4-5, 2002), welche z.B. durch eine Ablösung des Bonddrahtes 130 von einer Stromversorgung 131 hervorgerufen werden kann. In einem derartigen Fall kann z.B. eine Kontaktfläche zwischen dem Bonddraht 130 und der Stromversorgung 131 durch die Ablösung des Bonddrahtes 130 verkleinert werden. Dies kann zu einer Erhöhung des Widerstands der leitenden Verbindung zwischen z.B. einem IGBT und einer darunterliegenden Stromversorgung, verstanden werden. Dieser erhöhte Widerstand muss z.B. durch eine Ausgangsstromregelung des IGBT 110 kompensiert werden. Dies kann schließlich zu einer Erwärmung des IGBT 110 beitragen und damit dessen Degradation weiter vorantreiben.

In einigen Fällen kann es auch vorkommen, dass sich ein Bonddraht abhebt. Da in einem Hauptstrompfad meist mehrere Bonddrähte parallel geschaltet sind, führt ein Abheben eines Bonddrahts nicht unmittelbar zu einem Totalversagen des betreffenden IGBTs, jedoch kann sich durch das Abheben der Widerstand der Bondverbindungerhöhen was zu den vorgenannten Folgen führen kann.

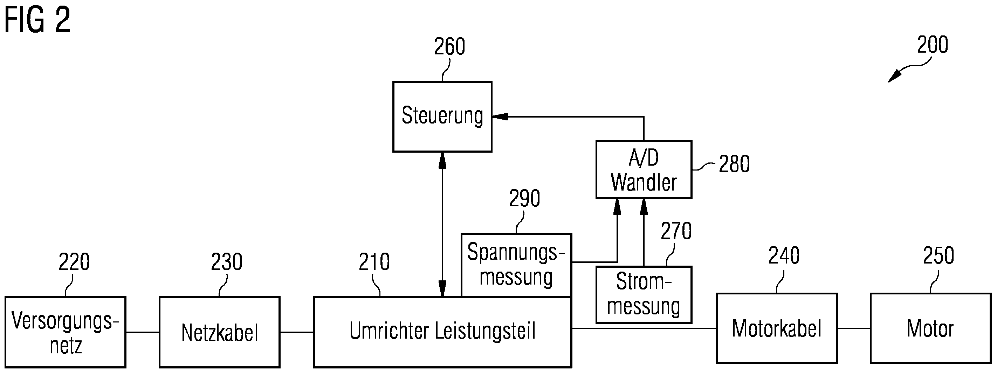

Fig. 2 zeigt ein exemplarisches System 200, welche ein Zusammenwirken eines Stromrichters (auch Umrichter) in einem möglichen erfindungsgemäßen Kontext zeigt.

Unter einem Stromrichter werden vorliegend Vorrichtungen verstanden, welche z.B. Wechselstrom in Gleichstrom umwandeln (Gleichrichter) oder Vorrichtungen, welche einen Gleichstrom in einen Wechselstrom umwandeln (Wechselrichter). Ferner kann unter einem Stromrichter auch ein Umrichter verstanden werden, welcher z.B. als Frequenzumrichter fungieren kann und z.B. eine Änderung einer Wechselstromfrequenz (d.h. einer Umwandlung der Frequenz eines Eingangswechselstroms in eine andere Frequenz eines Ausgangswechselstroms, z.B. über einen intermediären Gleichstrom) bewirken kann.

Das System 200 umfasst einen Umrichter (Leistungsteil) 210. Der Umrichter 210 wird von einem Versorgungsnetz 220 über ein Netzkabel 230 eingangsseitig mit Strom versorgt.

Ausgangsseitig kann der Umrichter 210 über ein Motorkabel 240 mit einem Motor 250 verbunden sein.

Umrichter 210 kann sich ferner mittels Steuerung 260 in einem geschlossenen Regelkreis befinden, welcher konfiguriert ist einen Ausgangsstrom des Umrichters 210 auf einem gewünschten, möglicherweise zeitabhängigen Wert zu halten.

Dies kann dadurch erreicht werden, dass ein Ausgangsstrom des Umrichters 210 durch eine Strommessung 270 gemessen wird (z.B. durch Messen eines um ein Kabel (z.B. Motorkabel 240) hervorgerufenen Magnetfelds). Das Resultat der Strommessung 270 kann eine zum Ausgangsstrom proportionale Spannung (z.B. proportionale Ausgangsspannung) sein, welche einem A/D Wandler 280 zugeführt werden kann.

A/D Wandler 280 kann dazu eingerichtet sein, die analoge Ausgangsspannung zu digitalisieren und damit in ein digitales Messsignal umzuwandeln.

Bevorzugt erfüllt die Abtastrate des A/D Wandlers 280 zumindest das Nyqvist-Kriterium. In einigen beispielhaften Fällen, wie hierin beschrieben, kann jedoch auch eine Überabtastung des Ausgangsstroms mittels A/D Wandler 280 vorgenommen werden.

In einigen Fällen kann auch eine dedizierte Spannungsmessung 290 (z.B. eine direkte Ausgangsspannung) vorgesehen sein. In einem derartigen beispielhaften Anwendungsfall kann der A/D Wandler 280 auch direkt die betreffende Ausgangsspannung abtasten.

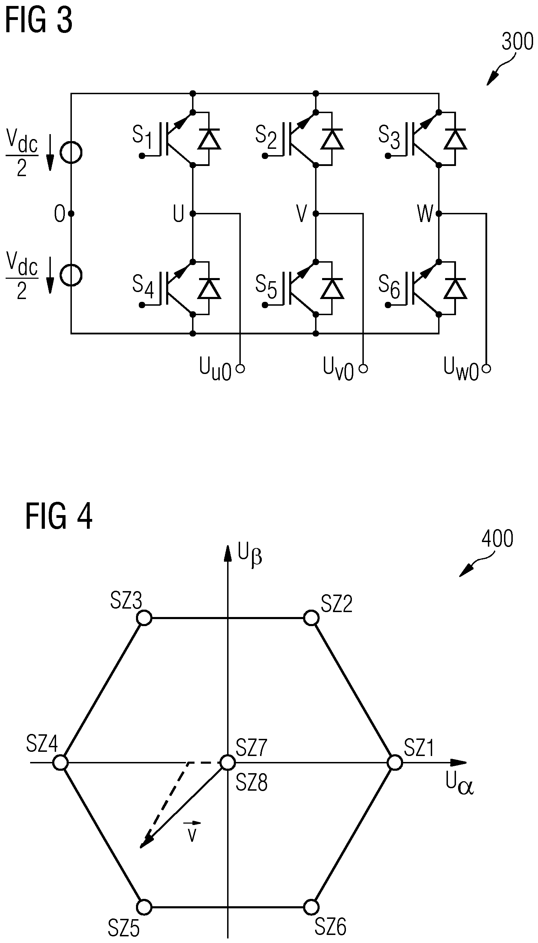

Fig. 3 zeigt ein exemplarisches Ersatzschaltbild einer Drehstrombrückenschaltung 300 gemäß Aspekten der vorliegenden Erfindung.

Drehstrombrückenschaltung 300 umfasst drei in einer oberen Hälfe der Drehstrombrückenschaltung 300 angeordnete Halbleitermodule S₁-S₃.

Drehstrombrückenschaltung 300 umfasst drei in einer unteren Hälfte der Drehstrombrückenschaltung 300 angeordnete Halbleitermodule S₄-S₆.

Alle oder zumindest einige der Halbleitermodule S₁-S₆ können als IGBTs bereitgestellt werden. Parallel zu jeder der IGBTs (welche als Transistoren dargestellt sind) kann eine jeweilige Diode geschaltet werden.

Drehstrombrückenschaltung wird vorliegend mit einer Gleichspannungsquelle V_{DC} betrieben.

Drehstrombrückenschaltung 300 umfasst ferner drei Klemmen uᵤ₀, uᵥ₀ und u_{w0}, über die eine 3-phasige Last an einen Ausgang der Drehstrombrückenschaltung 300 angeschlossen werden kann. Es sei jedoch darauf hingewiesen, dass auch Implementierungen mit weniger als drei Phasen oder Implementierungen mit mehr als drei Phasen möglich sind.

Ein Einschalten der oberen Halbleitermodule S₁-S₃ kann dazu führen, dass die drei Klemmen uᵤ₀, uᵥ₀ und u_{w0} mit einem positiven Zwischenkreispotential verbunden werden, wobei die Klemmen uᵤ₀, uᵥ₀ und u_{w0} jeweils an den entsprechenden Knoten U, V, W abgegriffen werden.

Analoges gilt für ein negatives Zwischenkreispotential, wenn die jeweiligen in der unteren Hälfte der Drehstrombrückenschaltung 300 angeordneten Halbleitermodule S₄-S₆ eingeschaltet werden.

Um einen Kurzschluss zu vermeiden, ist es von Bedeutung, die in der oberen Hälfte der Drehstrombrückenschaltung 300 angeordneten Halbleitermodule S₁-S₃ nicht gleichzeitig mit den in der unteren Hälfte der Drehstrombrückenschaltung 300 angeordneten Halbleitermodule S4-S6 zu betreiben. Ein paralleler Betrieb von Halbleitermodulen einer der beiden Hälften ist hingegen möglich. In einem derartigen Fall entscheidet das Stromvorzeichen einer jeweiligen Phase, ob ein negatives oder positives Zwischenkreispotential mit den Klemmen uᵤ₀, uᵥ₀ und u_{w0} verbunden ist.

Während einer mechanischen und/oder elektronischen Periode (Fundamentalperiode) können sich Szenarien ergeben, in welchen Gruppen von Halbleitermodulen für gewisse Zeitabschnitte für längere Zeiten beschaltet werden als dies für andere Gruppen von IGBTs der Fall sein kann. Dies kann sowohl in einer "two level" (Spannung kann zwischen zwei Werten geschaltet werden, wie z.B. ± *V_{DC}*/2) als auch in einer "multilevel" (Spannung kann zwischen mehr als zwei Werten geschaltet werden, wie z.B. drei Werten) Topologie auftreten.

Da Halbleitermodule meist gruppenweise beschaltet werden, können sich so zeitliche Sektoren ergeben, sodass ein von dem Stromrichter ausgegebenes Signal aus einer Superposition der jeweils beschalteten Halbleitermodulen ergibt. Eine Degradation eines Halbleitermoduls kann zu einer Veränderung der Perioden(-dauer, z.B. im Bereich einer Halbperiode oder Viertelperiode) führen, was durch eine einen Ausgang des Stromrichters regelnde Elektronik ausgeglichen werden muss und sich somit z.B. in einem P- und/oder I-Signals eines PI-Reglers widerspiegeln kann.

Es sei ferner angemerkt, dass jede einzelne Phase zwei verschiedene diskrete Schaltzustände (ein/aus) annehmen kann. Wird von drei Phasen ausgegangen, so ergeben sich insgesamt 2³ = 8 Schaltzustände.

Ein sequentielles Beschalten der Halbleitermodule der Drehstrombrückenschaltung 300 führt zu einem Durchlaufen von insgesamt sechs Schaltzuständen, welche in Form eines αβ-Diagramms 400 dargestellt werden können, wie in Fig. 4 dargestellt.

Fig. 4 zeigt ein αβ-Diagramm 400 umfassend einen Vektor *v̅* welcher in der αβ-Ebene rotiert und mit Hilfe der Schaltzustände SZ1-SZ6 nachgebildet wird, wobei jeder der Schaltzustände SZ1-SZ6 dem Beschalten eines respektiven Halbleitermoduls S₁-S₆ entspricht.

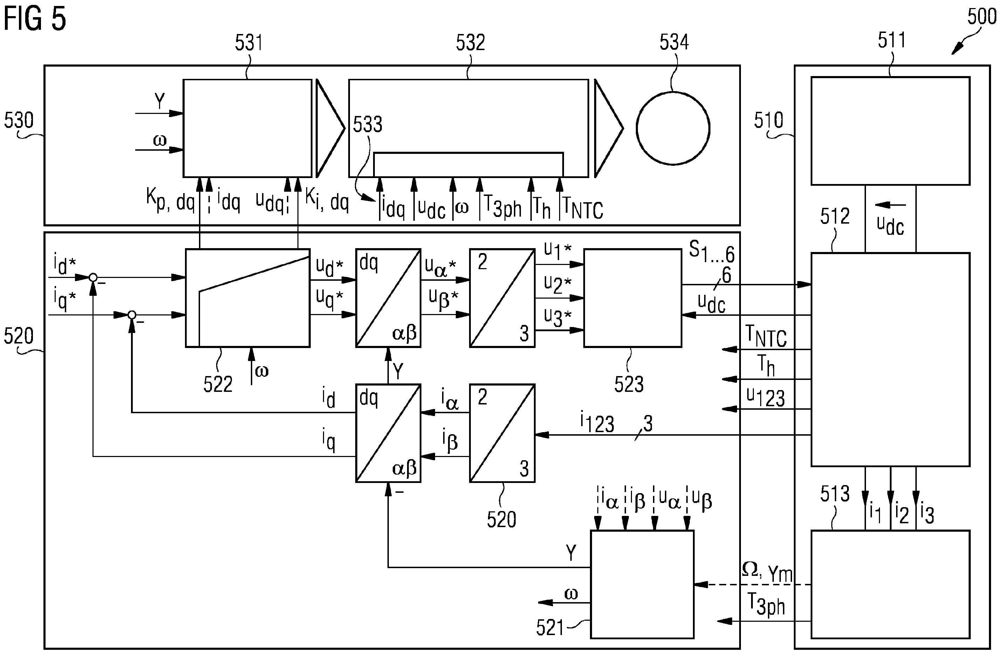

Fig. 5 zeigt einen Signalflussplan 500 eines Zusammenwirkens eines physischen Systems 510, eines Regelungssystems 520 sowie eines parallel zum Regelungssystems 520 geschalteten Condition Monitoring Systems 530.

Das physikalische System 510 kann dabei ein DC-System 511 umfassen. DC-System 511 kann zum Einsatz zusammen mit einem Stromrichter für ein elektrisches Antriebssystem bereitgestellt sein, welcher in der Regel eine Zwischenkreisspannung über eine Einspeisung zur Verfügung stellt (Diodengleichrichter, Active Front End (AFE), also einer aktiven Einspeisung, die aus einem Drehstromnetz einen Gleichspannungszwischenkreis zur Verfügung stellen kann). Grundsätzlich ist jedoch auch jede andere DC-Quelle bzw. -Last implementierbar, wie z.B. eine DC-Ladesäule oder ein Photovoltaik-Feld, etc. Die hierin diskutierten Ausführungen können z.B. auch auf AC-AC Umrichter (z.B. Matrixumrichter) angewendet werden.

Die von dem DC-System 511 zur Verfügung gestellte Spannung U_{DC} kann an einen Stromrichter 512 bzw. eine entsprechende Leistungselektronik zur Verfügung gestellt werden. Der Stromrichter 512 kann dabei z.B. als eine Drehstrombrückenschaltung (z.B. die Drehstrombrückenschaltung 300) bereitgestellt werden. Der Stromrichter 512 bzw. die Leistungselektronik besteht dabei nicht alleinig aus der Drehstrombrückenschaltung, sondern kann auch Sensoren zur Strommessung, Temperaturüberwachung, Spannungsmessung, etc. umfassen. Diese Sensoren können zusätzlich in das datenbasierte Condition Monitoring eingebunden werden.

Mit einem Ausgang des Stromrichters 512 ist schließlich ein drei-phasiges AC-System 513 verbunden, welches z.B. durch die drei Phasen i₁, i₂ und i₃ mit dem Stromrichter 512 verbunden sein kann, welche durch den Stromrichter 512 erzeugt wurden.

Das drei-phasige AC-System 513 kann als ein Elektromotor bzw. eine Asynchronmaschine oder eine Synchronmaschine bereitgestellt werden.

In einigen Fällen kann das drei-phasige AC-System 513 jedoch auch ein drei-phasiges elektrisches Netz sein.

Regelungssystem 520 kann auf einer feldorientierten Regelung (auch Vektorregelung) basieren. Bei der feldorientierten Regelung werden sinusförmige - oder als weitgehend sinusförmig angenommene - Wechselgrößen (beispielsweise Wechselspannungen und Wechselströme) nicht direkt in ihrem zeitlichen Momentanwert, sondern in einem um den Phasenwinkel innerhalb der Periode bereinigten Momentanwert geregelt. Zu diesem Zweck werden die erfassten Wechselgrößen jeweils in ein mit der Frequenz der Wechselgrößen rotierendes Koordinatensystem übertragen. Innerhalb des rotierenden Koordinatensystems ergeben sich dann aus den Wechselgrößen Gleichgrößen, auf die alle üblichen Verfahren der Regelungstechnik angewandt werden können.

In einer möglichen Implementierung kann dabei eine Transformation von Strommesswerten in ein (Rotor-) Flussbasiertes Koordinatensystems (dq-System) erfolgen. Ferner kann sich daran eine entkoppelte Regelung des feldbildenden Stroms (ausgedrückt durch die d-Achse) und des drehmomentbildenden Stroms (ausgedrückt durch die q-Achse) anschließen. Für jede der beiden Koordinatenachsen (d und q) kann ein entsprechender PI-Regler vorgesehen werden.

Ein Transformationswinkel des flussbasierten Koordinatensystems kann je nach Anwendungsfall direkt gemessen oder über eine Modellierung geschätzt werden, wie dies durch Flusswinkelbestimmungseinheit 521 ermöglicht werden kann.

Bei Asynchronmaschinen kann das Spannungs-/Strommodell auf Messgrößen basieren, bei Synchronmaschinen kann eine direkte Messung der Rotorlage erfolgen, bei einem elektrischen Netz kann ein Spannungsmodell bzw. eine Phasenregelschleife (engl.: *phase locked loop* (PLL)) basierend auf Messgrößen implementiert werden.

Durch einen Regelungsblock 522 kann aus einer Regelabweichung (z.B. durch einen Soll-/Istwertvergleich) eine Sollspannung berechnet werden, welche vom Stromrichter 512 ausgeben werden muss, um die Regelabweichung zu minimieren, idealerweise auf null zu setzen. Die so bestimmte Sollspannung kann aus dem flussbasierten Koordinatensystem rücktransformiert werden und als Spannungssollwerte für die drei Phasen des betrachteten Systems verwendet werden.

Innerhalb des Modulators 523 können aus den Sollspannungen zusammen mit einer gemessenen Zwischenkreisspannung die Schaltzeitpunkte für die Leistungshalbleiter berechnet und als Ansteuersignale an den Stromrichter übergeben werden.

Strom iᵢ₂₃ kann für die Stromregelung in das dq-System überführt werden und die eigentliche Stromregelung im dq-System ausgeführt werden. Nach Berechnung der eigentlichen Regelungsgrößen kann eine Rücktransformation in ein physischen System erfolgen um die eigentliche Regelung ausführen zu können.

Das Condition Monitoring 530 kann derart bereitgestellt werden, dass es die verfügbaren Mess-und/oder Reglergrößen auswerten kann. Dies kann z.B. einen P- und/oder I-Teil der beiden Pl-Regler umfassen, gemessene Ströme und/oder gemessene Spannungen. Diese können jeweils als zeitlicher Verlauf erfasst worden sein.

In einem ersten Schritt können in einer Fenster- bzw. Analyseeinheit 531 die verfügbaren Daten mittels eines auf eine elektrische oder mechanische Periode abgestimmten Fensters (z.B. durch Falten mit einer Fensterfunktion) vorbearbeitet werden. Hieran anschließen kann sich das Ausführen einer Frequenzanalyse, z.B. das Ausführen einer FFT, einer Fourier-Serie, etc. Hieraus können dazugehörige Fourierkoeffizienten (Amplitude und Phasenlage) der im Signal des erfassten zeitlichen Verlaufs enthaltenen Oberwellen.

Das Ausführen einer derartigen Frequenzanalyse kann zyklisch und damit wiederholt ausgeführt werden. Dies kann ein Überwachen einer möglichen Änderung der Fourierkoeffizienten im Zeitverlauf ermöglichen.

Basierend hierauf kann mittels einer Condition Monitoring Überwachungseinheit 532 ein Bestimmen erfolgen, z.B. durch Vergleichen der Fourierkoeffizienten mit Referenz-Fourierkoeffizienten, ob ein Voranschreiten des Degradationsfortschritts erfolgt ist.

Zusätzlich können in das datenbasierte Condition Monitoring weitere Umweltbedingungen 533 mit einfließen (z.B. eine Luftfeuchtigkeit, Umgebungstemperatur, etc.). Bei gleichbleibenden Umweltbedingungen kann aus einer Veränderung der Fourierkoeffizienten so auf ein Voranschreiten einer Degradation geschlossen werden, wodurch auf einen beginnenden Fehler im betrachteten System geschlossen werden kann. In anderen Worten, typische Fehlerbilder in Drehstrombrückenschaltungen können typischerweise zu entsprechenden Signaturen in den untersuchten höheren Harmonischen führen.

Basierend hierauf kann Überwachungseinheit 532 dann einen Gesundheitszustand 534 (engl.: *state of health* (SOH)) des betrachteten Systems bestimmen.

Wird eine Phasenlage der betrachteten höheren Harmonischen bestimmt, so kann eine Fehlerlokalisation dahingehend erfolgen, welches der Halbleitermodule möglicherweise von einem Fehler bzw. Ausfall betroffen ist, wie oben bereits beschrieben.

Es sei angemerkt, dass das Condition Monitoring 530 physisch in dem physischen System 510 enthalten sein kann (z.B. als Teil des drei-phasigen AC-Systems 513; in einigen Fällen kann das Condition Monitoring 530 auch Teil des Regelungssystems 520 sein und dort z.B. als Softwareeinheit implementiert sein). Alternativ kann es auch möglich sein, dass das Condition Monitoring 530 in einer entfernten Entität (z.B. als Cloud-Dienst, als Edge-Gerät, etc.) vorgehalten wird, welche z.B. mit dem physischen System 510 und/oder dem Regelungssystem 520 in Kommunikationsverbindung steht.

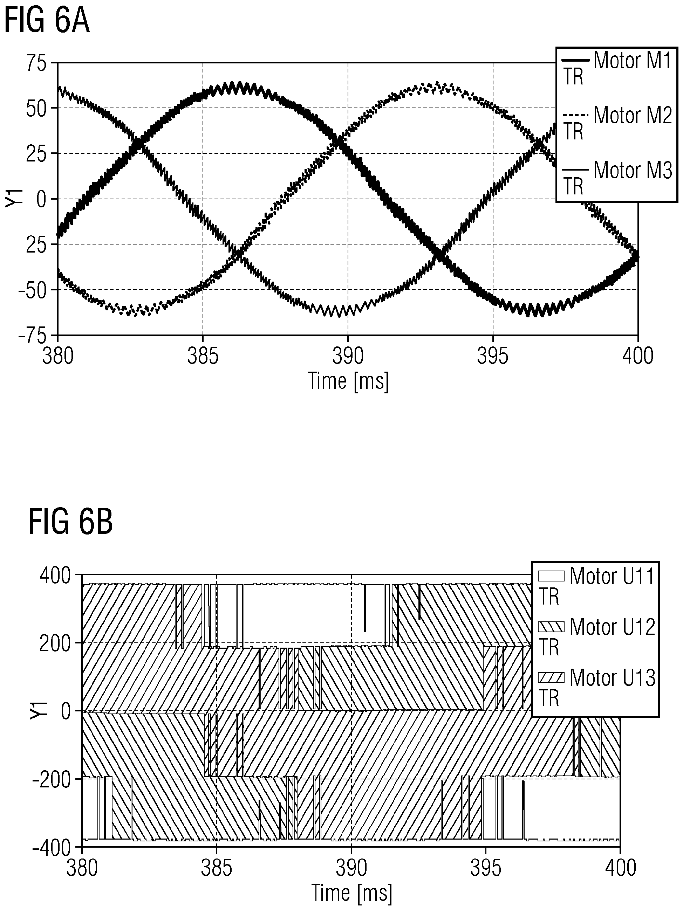

Fign. 6A und 6B zeigen exemplarische Simulationen von (initialen) Zustandsgrößen, wie diese z.B. durch ein Digital Twin Model erhalten werden können.

Fig. 6A zeigt einen exemplarischen zeitlichen Verlauf von möglichen Eingangsströmen (für z.B. drei Phasen) wie sie einem elektrischen Antriebsmittel zugeführt werden können (und damit ggf. als Ausgangsstrom am Ausgang eines Stromrichters auftreten können). Auf diese Weise kann z.B. für ein gegebenes Antriebsmittel und einen gegebenen Stromrichter eine Amplitude (d.h. ein maximaler) eines Eingangsstroms simuliert werden. Ebenso kann auf diese Weise z.B. bestimmt werden, welcher Eingangsstrom z.B. zu welchem Zeitpunkt (z.B. in ms) erwartet werden kann.

Fig. 6B zeigt im Vergleich dazu mögliche Eingangsspannungen (für z.B. drei Phasen) wie sie sie einem elektrischen Antriebsmittel zugeführt werden können (und damit ggf. als Ausgangsspannung am Ausgang eines Stromrichtes auftreten können).

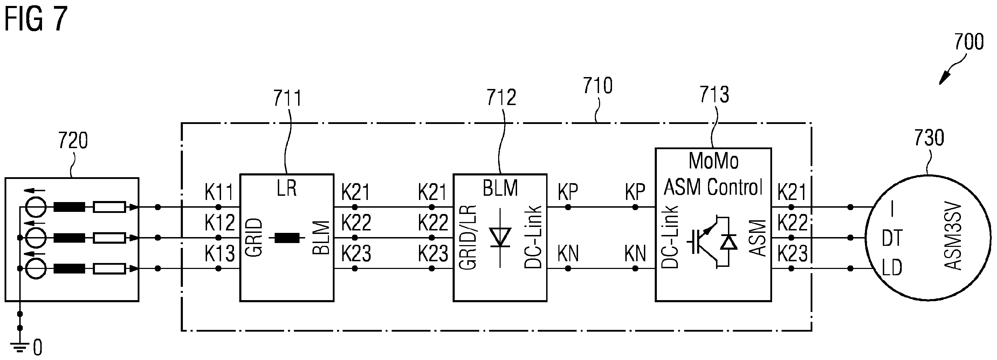

Fig. 7 zeigt ein Systemdiagramm 700 eines Stromrichters 710, wie dieser z.B. durch das mit Bezug zu Fign. 6A und 6B erläuterte Digital Twin Model, simultiert werden kann.

Stromrichter 710 wird zwischen einer Netzquelle 720 (d.h. eines Versorgungsnetzes, bevorzugt 3-phasig, wie durch die Phasen K11, K12 und K13 angedeutet) und einem elektrischen Antriebsmittel 730 eingebettet. Das elektrische Antriebsmittel 730 kann als Motor (z.B. Elektromotor) bereitgestellt werden. Insbesondere kann das elektrische Antriebsmittel 730 als Synchronmaschine oder Asynchronmachine bereitgestellt werden.

Stromrichter 730 kann insbesondere eine Netzdrossel 711, einen Netzgleichrichter 712 sowie einen Motorwechselrichter 713 umfassen.

Unter einer Netzdrossel 711 kann eine Vorrichtung verstanden werden, welche z.B. Spulen bzw. Induktivitäten umfasst, um eine Begrenzung von Strömen in elektrischen Leitungen sicherzustellen und/oder zur Impedanzanpassung und/oder zur Filterung einer Eingangsspannung, welche z.B. von der Netzquelle 720 bereitgestellt wird. Der Ausgang der Netzdrossel 711 wird durch die Phasen K21, K22 und K23 angezeigt.

Netzgleichrichter 712 kann derart konfiguriert sein, dass dieser einen Wechselstrom, welcher z.B. von der Netzquelle 720 bereitgestellt werden kann, in einen Gleichstrom umwandelt. Die beiden dadurch resultierenden Phasen werden vorliegend durch KP und KN beschrieben.

Motorwechselrichter 713 kann so konfiguriert sein, dass dieser die durch den Netzgleichrichter 712 bereitgestellte Gleichspannung in einen Wechselspannung (3-phasig, angezeigt durch die entsprechenden Phasen K21, K22, K23) umwandelt, um den Erfordernissen des verwendeten elektrischen Antriebsmittels 730 zu genügen.

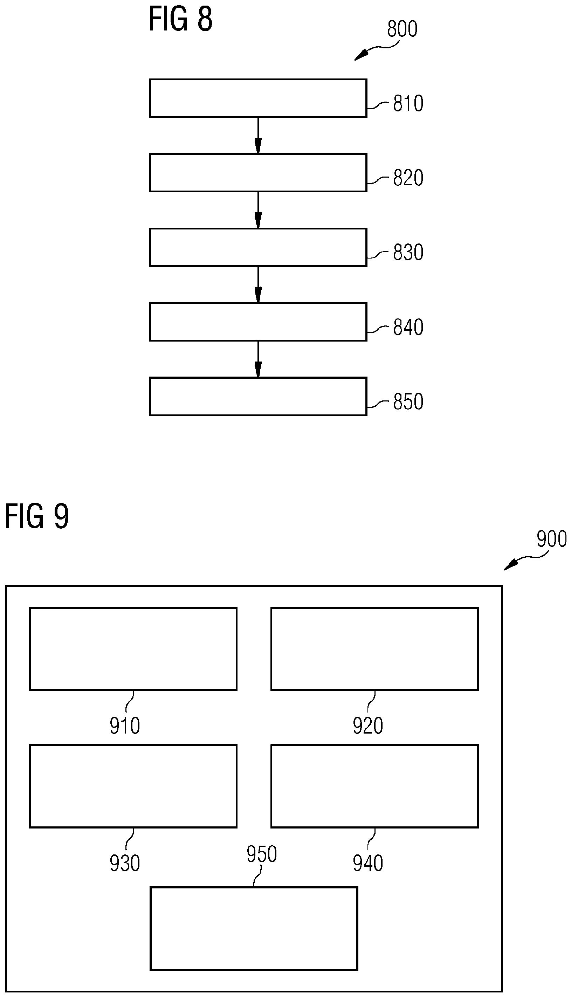

Fig. 8 zeigt ein Ablaufdiagramm eines exemplarischen Computer-implemenierten Verfahrens 800 zum Bestimmen eines Degradationsfortschritts eines Stromrichters und/oder eines elektrischen Antriebsmittels gemäß einem Aspekt der vorliegenden Erfindung.

In Schritt 810 erfolgt ein Erfassen eines zeitlichen Verlaufs einer initialen mit einer Reglung einer Ausgangsspannung und/oder einem Ausgangsstrom assoziierten zumindest einen Zustandsgröße, wobei die Ausgangsspannung und/oder der Ausgangsstrom des Stromrichters zur Zuführung an das elektrische Antriebsmittel bestimmt ist.

In Schritt 820 erfolgt ein Erfassen eines zeitlichen Verlaufs der zumindest einen Zustandsgröße zu einem späteren, von einem mit der initialen Zustandsgröße assoziierten, verschiedenem Zeitpunkt.

In Schritt 830 erfolgt ein Bestimmen, ob eine Abweichung eines mit dem erfassten zeitlichen Verlaufs der Zustandsgröße zu dem späteren Zeitpunkt assoziierten Wertes von einem mit dem zeitlichen Verlaufs der initialen Zustandsgröße assoziierten Werts eingetreten ist.

In Schritt 840 erfolgt ein Bestimmen, falls eine Abweichung bestimmt wurde, einer mit einer Degradation des Stromrichters assoziierten Zeitkonstante mit welcher die Abweichung eingetreten ist.

In Schritt 850 erfolgt ein Bestimmen, zumindest teilweise basierend auf der Zeitkonstante, einer Degradationsursache und eines Degradationsfortschritts, zumindest teilweise basierend auf einem Vergleichen der bestimmten Abweichung mit einer Referenzabweichung.

Fig. 9 zeigt eine exemplarische Computer-implementierte Vorrichtung 900 zum Bestimmen eines Degradationsfortschritts eines Stromrichters und/oder eines elektrischen Antriebsmittels gemäß einem Aspekt der vorliegenden Erfindung. Die Computer-implementierte Vorrichtung 900 umfasst eine erste Erfassungseinheit 910, eine zweite Erfassungseinheit 920, eine erste Bestimmungseinheit 830, eine zweite Bestimmungseinheit 840 sowie eine dritte Bestimmungseinheit 850.

Erste Erfassungseinheit 910 ist konfiguriert zum Erfassen eines zeitlichen Verlaufs einer initialen mit einer Reglung einer Ausgangsspannung und/oder einem Ausgangsstrom des Stromrichters assoziierten zumindest einen Zustandsgröße, wobei die Ausgangsspannung und/oder der Ausgangsstrom zur Zuführung an das elektrische Antriebsmittel bestimmt ist.

Zweite Erfassungseinheit 920 ist konfiguriert zum Erfassen eines zeitlichen Verlaufs der zumindest einen Zustandsgröße zu einem späteren, von einem mit der initialen Zustandsgröße assoziierten, verschiedenem Zeitpunkt.

Erste Bestimmungseinheit 930 ist konfiguriert zum Bestimmen, ob eine Abweichung eines mit dem erfassten zeitlichen Verlaufs zu dem späteren Zeitpunkt assoziierten Wertes von einem mit dem zeitlichen Verlaufs der initialen Zustandsgröße assoziierten Werts eingetreten ist.

Zweite Bestimmungseinheit 940 ist konfiguriert zum Bestimmen, falls eine Abweichung bestimmt wurde, einer mit einer Degradation des Stromrichters assoziierten Zeitkonstante mit welcher die Abweichung eingetreten ist.

Dritte Bestimmungseinheit 950 ist konfiguriert zum Bestimmen, zumindest teilweise basierend auf der Zeitkonstanten, einer Degradationsursache und eines Degradationsfortschritts, zumindest teilweise basierend auf einem Vergleichen der bestimmten Abweichung mit einer Referenzabweichung.

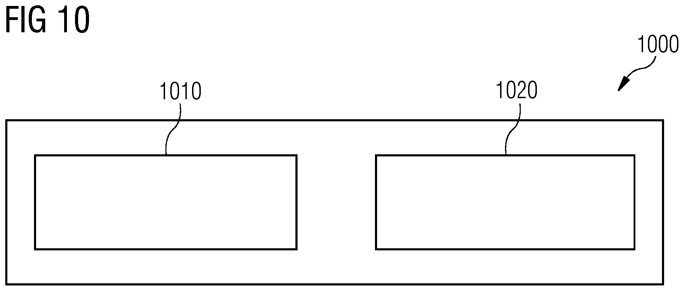

Fig. 10 zeigt ein exemplarisches System 1000 zum Bestimmen eines Degradationsfortschritts eines Stromrichters und/oder eines elektrischen Antriebsmittels gemäß einem Aspekt der vorliegenden Erfindung. Das System 1000 beinhaltet eine Computer-implementierte Vorrichtung 1010 und ein Computerprogrammprodukt 1020.

Die Computer-implementierte Vorrichtung 1010 kann konfiguriert sein, wie hierin beschrieben.

Das Computerprogrammprodukt 1020 kann konfiguriert sein, wie hierin beschrieben.

Obwohl die vorliegende Erfindung anhand von Ausführungsbeispielen beschrieben wurde, ist sie vielfältig modifizierbar.

Unabhängig vom grammatikalischen Geschlecht eines bestimmten Begriffes sind Personen mit männlicher, weiblicher oder anderer Geschlechteridentität mit umfasst.

## Patentansprüche

1. Computer-implementiertes Verfahren (800) zum Bestimmen eines Degradationsfortschritts eines Stromrichters und/oder eines elektrischen Antriebsmittels, umfassend:
Erfassen (810) eines zeitlichen Verlaufs einer initialen mit einer Reglung einer Ausgangsspannung und/oder einem Ausgangsstrom assoziierten zumindest einen Zustandsgröße, wobei die Ausgangsspannung und/oder der Ausgangsstrom des Stromrichters zur Zuführung an das elektrische Antriebsmittel bestimmt ist;
Erfassen (820) eines zeitlichen Verlaufs der zumindest einen Zustandsgröße zu einem späteren, von einem mit der initialen Zustandsgröße assoziierten, verschiedenem Zeitpunkt;
Bestimmen (830), ob eine Abweichung eines mit dem erfassten zeitlichen Verlaufs der Zustandsgröße zu dem späteren Zeitpunkt assoziierten Wertes von einem mit dem erfassten zeitlichen Verlaufs der initialen Zustandsgröße assoziierten Werts eingetreten ist;
Bestimmen (840), falls eine Abweichung bestimmt wurde, einer mit einer Degradation des Stromrichters assoziierten Zeitkonstante mit welcher die Abweichung eingetreten ist;
Bestimmen (850), zumindest teilweise basierend auf der Zeitkonstante, einer Degradationsursache und eines Degradationsfortschritts, zumindest teilweise basierend auf einem Vergleichen der bestimmten Abweichung mit einer Referenzabweichung.

2. Computer-implementiertes Verfahren nach Anspruch 1, wobei die mit der Regelung assoziierte zumindest eine Zustandsgröße ein I-Anteil eines PI-Reglers, ein P-Anteil eines PI-Reglers, ein Ausgabewert eines Fehlerspeichers, ein Ausgabewert einer Vorsteuerung und/oder ein Zwischenergebnis ist.

3. Computer-implementiertes Verfahren nach einem der Ansprüche 1 oder 2, das Bestimmen der Degradationsursache ferner umfassend:
Bestimmen, dass die Abweichung über einen Zeitraum von zumindest einem Monat aufgetreten ist und basierend darauf mit einer Alterung des Stromrichters assoziiert werden kann; oder
Bestimmen, dass die Abweichung über einen Zeitraum von mindestens einer Minute und weniger als einem Tag aufgetreten ist und basierend darauf mit einer Temperaturveränderung des Stromrichters assoziiert werden kann; oder
Bestimmen, dass die Abweichung über einen Zeitraum von weniger als einer Minute aufgetreten ist und basierend darauf mit Lastsprüngen assoziiert werden kann.

4. Computer-implementiertes Verfahren nach einem der Ansprüche 1-3, das Bestimmen, ob eine Abweichung eingetreten ist, ferner umfassend:
Bestimmen einer Differenz zwischen dem Wert der initialen Zustandsgröße und dem Wert der Zustandsgröße zu dem späteren Zeitpunkt; und/oder
Bestimmen einer Differenz einer Amplituden einer höhereren Harmonischen der initialen Zustandsgröße und einer Amplitude einer höheren Harmonische der Zustandsgröße zu einem späteren Zeitpunkt.

5. Computer-implementiertes Verfahren nach einem der Ansprüche 1-4, wobei das Erfassen des zeitlichen Verlaufs der initialen Zustandsgröße ein Erfassen des zeitlichen Verlaufs der initialen Zustandsgröße zumindest teilweise basierend auf einem Resultat einer Simulation des Stromrichters und/oder des elektrischen Antriebsmittels mittels eines Digital Twin Models umfasst.

6. Computer-implementiertes Verfahren nach Anspruch 5, wobei das Resultat der Simulation mit einem Gleichanteil und/oder einer höheren Harmonischen, bevorzugt einer 1., 2. oder 6. Harmonischen, eines zeitlichen Verlaufs der Ausgangsspannung und/oder des Ausgangsstroms assoziiert ist.

7. Computer-implementiertes Verfahren nach einem der Ansprüche 1-6, wobei der erfasste zeitliche Verlauf der initialen Zustandsgröße zumindest teilweise auf einer Leerlaufmessung des elektrischen Antriebs bei variabler oder fester elektrischer Frequenz basiert oder auf einer Messung von Betriebspunkten mit einem nicht-rotierenden Rotor des elektrischen Antriebs.

8. Computer-implementiertes Verfahren nach einem der Ansprüche 5 oder 6 und Anpruch 7, wobei das Erfassen des zeitlichen Verlaufs der initialen Zustandsgröße auf einem Resultat der Simulation basiert und mittels der Leerlaufmessung oder der Messung von Betriebspunkten weiter an ein reales System angepasst wird.

9. Computer-implementiertes Verfahren nach einem der Ansprüche 1-8, wobei der zeitliche Verlauf der initialen Zustandsgröße mit einem fehlerfreien Zustand des Stromrichters assoziiert ist.

10. Computer-implementiertes Verfahren nach einem der Ansprüche, ferner umfassend:
Nachführen, zumindest teilweise basierend auf dem bestimmten Degradationsfortschritts, eines Reglers, um die Ausgangsspannung und/oder den Ausgangsstrom auf einen vorbestimmten Wert zu regeln.

11. Computer-implementiertes Verfahren nach einem der Ansprüche 1-10, wobei der Stromrichter ein 3-phasiger 2-Level Wechselrichter ist; wobei der Stromrichter zumindest ein Halbleitermodul, bevorzugt sechs Halbleitermodule umfasst; und
wobei das zumindest eine Halbleitermodul bevorzugt ein Bipolartransistor mit isolierter Gate Elektrode, IGBT, oder ein SiC- metal-oxide-semiconductor field-effect transistor, MOSFET, ist.

12. Computerprogrammprodukt, umfassend Befehle, die bei der Ausführung des Programms durch einen Computer diesen veranlassen, das Verfahren nach einem der Ansprüche 1 - 11 auszuführen.

13. Computer-implementierte Vorrichtung (900) zum Bestimmen eines Degradationsfortschritts eines Stromrichters und/oder eines elektrischen Antriebsmittels, umfassend:
Eine erste Erfassungseinheit (910) zum Erfassen eines zeitlichen Verlaufs einer initialen mit einer Reglung einer Ausgangsspannung und/oder einem Ausgangsstrom des Stromrichters assoziierten zumindest einen Zustandsgröße, wobei die Ausgangsspannung und/oder der Ausgangsstrom zur Zuführung an das elektrische Antriebsmittel bestimmt ist;
Eine zweite Erfassungseinheit (920) zum Erfassen eines zeitlichen Verlaufs der zumindest einen Zustandsgröße zu einem späteren, von einem mit der initialen Zustandsgröße assoziierten, verschiedenem Zeitpunkt;
Eine erste Bestimmungseinheit (930) zum Bestimmen, ob eine Abweichung eines mit dem erfassten zeitlichen Verlaufs zu dem späteren Zeitpunkt assoziierten Wertes von einem mit dem erfassten zeitlichen Verlaufs der initialen Zustandsgröße assoziierten Werts eingetreten ist;
Eine zweite Bestimmungseinheit (940) zum Bestimmen, falls eine Abweichung bestimmt wurde, einer mit einer Degradation des Stromrichters assoziierten Zeitkonstante mit welcher die Abweichung eingetreten ist;
Eine dritte Bestimmungseinheit (950) zum Bestimmen, zumindest teilweise basierend auf der Zeitkonstanten, einer Degradationsursache und eines Degradationsfortschritts, zumindest teilweise basierend auf einem Vergleichen der bestimmten Abweichung mit einer Referenzabweichung.

14. Computer-implementierte Vorrichtung nach Anspruch 13, ferner umfassend:
eine Ausführungseinheit zum Ausführen des Computerprogrammprodukts nach Anspruch 12;
und/oder
eine weitere Ausführungseinheit zum Ausführen des Verfahrens nach einem der Ansprüche 1-11.

15. System (1000) zum Bestimmen eines Degradationsfortschritts eines Stromrichters, umfassend:
Computerprogrammprodukt (1010) nach Anspruch 12; und
Computer-implementierte Vorrichtung (1020) nach einem der Ansprüche 13 oder 14.
